# EUROPEAN PATENT SPECIFICATION

(11) **EP 1 699 077 B1**
(45) Date of publication and mention of the grant of the patent: **24.02.2010**
(21) Application number: 04820676.7
(22) Date of filing: 07.12.2004
(51) Int. Cl.: H01L 21/31, C23C 16/44

(54) **PLASMA PROCESSING APPARATUS**
PLASMAVERARBEITUNGSVORRICHTUNG
APPAREIL DE TRAITEMENT AU PLASMA

(30) Priority: 24.12.2003 JP 2003426648
(43) Date of publication of application: 06.09.2006
(73) Proprietor: MITSUBISHI HEAVY INDUSTRIES, LTD., Tokyo 108-8215 (JP)
(72) Inventor: KAWANO, Yuichi, Takasago-shi (JP); SHIMAZU, Tadashi, Takasago-shi (JP); NISHIMORI, Toshihiko, Takasago-shi (JP); YOSHIDA, Kazuto, Kobe-shi, Hyogo (JP)
(74) Representative: HOFFMANN EITLE
(86) International application number: PCT/JP2004/018187
(87) International publication number: WO 2005/062362

(56) References cited:
- EP-A2- 0 732 729
- JP-A- 2 183 533
- JP-A- 7 335 567
- JP-A- 8 031 751
- JP-A- 8 185 997
- JP-A- 2001 044 179
- JP-A- 2002 222 767
- US-A- 5 637 237
- US-A1- 2002 100 423
- US-B1- 6 394 026

## Description

### Technical Field

This invention relates to a plasma processing apparatus suppressing the generation of particles during plasma processing.

### Background Art

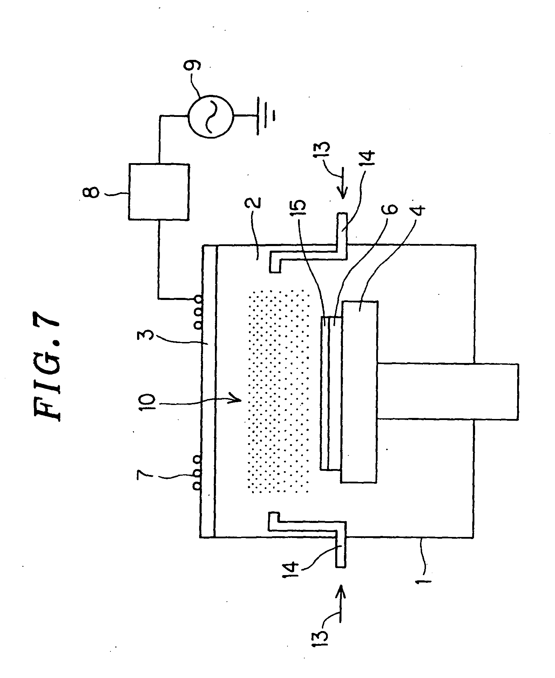

Currently, plasma processing methods using a plasma CVD (chemical vapor deposition) apparatus, a plasma etching apparatus, etc. are known for the production of semiconductor devices. Fig. 7 is a schematic perspective sectional side view of a thin film production apparatus (plasma CVD apparatus) which is an example of a conventional plasma processing apparatus.

As shown in the drawing, the plasma CVD apparatus is an apparatus in which a gas of an organometallic complex or the like (a source gas) 13, introduced into a vacuum chamber 1 and serving as a material for a thin film, is converted into a plasma state 10 by a high frequency wave thrown from a high frequency antenna 7, so that a chemical reaction on the surface of a substrate 6 is promoted by active excited atoms in the plasma 10 to form a metallic thin film 15 or the like.

In the above plasma CVD apparatus and the relevant film-forming method, the metallic thin film or the like (will hereinafter be referred to as a thin film component), which should essentially be formed on the substrate, may adhere to or deposit on the inner wall of the chamber, etc. according to the repetition of the film-forming step. The thin film component deposited on the inner wall of the chamber, etc. peels off during the film-forming step, constituting a cause of contaminating the substrate as a particle source.

A proposal has been made for a film-forming apparatus which aims at improving the uniformity of the distribution and flow of the gas within the chamber, and can eventually prepare a uniform thin film (see Patent Document 1 shown below). This film-forming apparatus has a structure similar to that of a thin film production apparatus according to the present invention which will be described later. However, no measure against the adhesion or deposition of the above thin film component has been taken for a portion in the film-forming apparatus, such as "annular protrusion (numeral 19)", to which the thin film component is apt to adhere. That is, in regard to the problem of the adhesion or deposition of the thin film component, the annular protrusion, etc. are not different at all from the inner wall surface of the chamber, for reasons such that the annular protrusion is fixed to the chamber by welding or the like.

Patent Document 1: Japanese Patent Application Laid-Open No. 2003-17477.
EP 0 732 729 A2 discloses a microwave plasma processing apparatus having a chamber and an inner cylinder of nonmagnetic material such as ceramic or aluminium. The inner cylinder 6 serves, by its choice of material, to avoid contamination by heavy metals, and is supported between an outer cylinder and a supporting element 32, which allows for an exchange of the inner cylinder once it is worn.
US 2002/100423 A1 relates to a method of fabricating a jig for a vacuum apparatus having a vacuum chamber. Vacuum apparatus jigs are disposed within the vacuum chamber 31 for preventing adhesions on internal surfaces within the chamber. The jigs are supported on the bottom of the vacuum chamber.
US 6,394,026 B1 describes a low contamination plasma etch chamber. A preferably cylindrical chamber liner is provided within the chamber and is made of ceramic material. A liner support is arranged between the chamber liner and the chamber housing and provides for insulation. The liner is held between a baffle ring and a lower extension of the liner support for good thermal contact.
US 5,637,237 A discloses an apparatus for etching semiconductor devices. Its plasma etching chamber is provided with a heatable chamber liner which is arranged around a gas nozzle and a substrate holder and may be coupled to a heating source. There is no dislosure about how the liner is supported.

### Disclosure of the Invention

### Problems to be solved by the invention

In forming the film with the use of the conventional plasma CVD apparatus, therefore, it has been necessary to perform cleaning treatment of the interior of the chamber periodically, thereby removing the thin film component that has adhered or deposited. In performing the cleaning treatment frequently, moreover, this treatment has become the cause of lowering the productivity of the thin film.

To carry out cleaning of the interior of the chamber, for example, by etching, it is desirable to heat the site to be cleaned, thereby increasing the etching rate (cleaning speed). However, the chamber is difficult to heat sufficiently by heating with plasma alone, and a heating device or the like needs to be provided separately in order to raise the cleaning speed. This is a problem in common with a plasma etching apparatus where a reaction product is formed by an etching reaction.

The present invention has been accomplished in the light of the above-described situations. It is an object of the invention to provide a plasma processing apparatus which has suppressed the generation of particles as the cause of substrate contamination to obviate the necessity for cleaning treatment of the interior of the chamber, or decrease the frequency of the cleaning treatment, or reduce the burden of work for the cleaning treatment.

### Means for Solving the Problems

A plasma processing apparatus according to the present invention, designed to solve the above-mentioned problems, is a plasma processing apparatus as defined in claim 1.

The wall surface protecting member is allowed to be contaminated instead, thereby preventing the adhesion or deposition of the plasma processing-associated product onto the inner wall surface of the chamber. Also, the wall surface protecting member is arranged to be detachable from the chamber, thereby rendering cleaning treatment of the interior of the chamber unnecessary. Moreover, a plurality of the wall surface protecting members are rendered ready for use to eliminate the interruption of the processing process due to a wait for the cleaning treatment of the wall surface protecting member, thereby increasing the production efficiency for semiconductor devices.

In the above plasma processing apparatus, the wall surface protecting member is an inner cylinder covering the inner wall surface of the chamber which is located above the susceptor.

Most of the particle source is ascribed to the plasma processing-associated product which has adhered to the inner wall surface of the chamber located above the susceptor (substrate). Thus, the inner cylinder covering the relevant site throughout the circumference of the interior of the chamber is used as the wall surface protecting member, whereby the generation of particles is suppressed effectively.

The plasma processing apparatus is also characterized in that the wall surface protecting member is supported on the chamber by point contact.

The expression "supported by point contact" refers to the fact that the wall surface protecting member is installed on the chamber via a plurality of small projections provided on the inner wall surface of the chamber or on the wall surface protecting member, namely, that the wall surface protecting member is installed, with the area of contact between the wall surface protecting member and the chamber being small.

The area of contact between the wall surface protecting member and the chamber is rendered as small as possible (the minimal area that can support the wall surface protecting member), whereby heat transfer from the wall surface protecting member heated by the plasma is suppressed. The wall surface protecting member is held at a high temperature, whereby the plasma processing-associated product adhering to the wall surface protecting member is caused to adhere with high uniformity and adhesive force (peeling lessens). If heating with plasma is poor, a heater may be provided to the wall surface protecting member for temperature control.

The wall surface protecting member of the plasma processing apparatus may be made of a ceramic.

When the material for the wall surface protecting member is a ceramic, plasma resistance is enhanced, and a long life is ensured. Also, there can be realized the plasma processing apparatus of a type having plasma generation means which is a coiled antenna wound around the outside of the side wall surface of the chamber.

The wall surface protecting member of the plasma processing apparatus may be made of a metal.

The metal may be aluminum.

When the material for the wall surface protecting member is rendered aluminum, the member is improved in durability, and rendered lightweight to lessen the burden of replacement work.

The wall surface protecting member of the plasma processing apparatus may have a surface oxidized.

By oxidizing the surface of the wall surface protecting member, its corrosion resistance and wear resistance are improved.

The wall surface protecting member of the plasma processing apparatus may have a surface roughened.

Blasting, for example, is named as the roughening. By performing this treatment, the adhesion of the adhering product is improved, and the adhered product is prevented from peeling off to contaminate the substrate.

The plasma processing apparatus may have the gas supply means passing through a hole provided in the wall surface protecting member.

The neighborhood of the site where the reactant gas is introduced, namely, the neighborhood of the nozzle tip of the gas supply means (gas nozzle), is particularly prone to the adhesion of the plasma processing-associated product serving as the particle source. If the piping of the gas nozzle is exposed to the interior of the film formation compartment, therefore, the plasma processing-associated product adheres to the exposed portion, becoming the particle source, or necessitating separate cleaning treatment. Thus, the gas nozzle is disposed while being passed through the through-hole provided in the wall surface protective member, whereby the portion of the gas piping exposed to the interior of the plasma processing compartment is shortened to solve such problems.

In an example not forming part of the invention, the plasma processing apparatus may have a heat insulator provided between the wall surface protecting member and the chamber.

The heat insulator would be provided between the wall surface protecting member and the chamber to suppress the heat loss of the wall surface protecting member heated by the plasma. Also, according to an example not forming part of the invention the wall surface protecting member is supported on the inner wall surface of the vacuum chamber by the heat insulator to eliminate heat transfer due to direct contact.

The plasma processing apparatus may also have heating means for heating the wall surface of the chamber.

The heating means may heat the wall surface of the chamber to 100°C or higher.

By heating the chamber itself to 100°C or higher, the temperature of the wall surface protecting member is stabilized.

### Effects of the Invention

The plasma processing apparatus according to the present invention is a plasma processing apparatus according to claim 1.
Thus, the adhesion or deposition of the plasma processing-associated product onto the inner wall surface of the chamber can be prevented. Also, the wall surface protecting member is arranged to be detachable from the chamber, whereby the cleaning treatment of the interior of the chamber can be rendered unnecessary. Moreover, the plurality of the wall surface protecting members are rendered ready for use, so that the interruption of the processing process due to a wait for the cleaning treatment of the wall surface protecting member is eliminated, whereby the production efficiency for semiconductor devices can be increased.

In the above plasma processing apparatus, the wall surface protecting member is an inner cylinder covering the inner wall surface of the chamber which is located above the susceptor.
Thus, in view of the fact that most of the particle source is ascribed to the plasma processing-associated product adhering to the inner wall surface of the chamber located above the susceptor (substrate), the generation of particles can be suppressed effectively.

In the plasma processing apparatus, the wall surface protecting member is supported on the chamber by point contact.
Thus, the area of contact between the wall surface protecting member and the chamber is rendered small, whereby heat transfer from the wall surface protecting member heated by the plasma can be suppressed. That is, the wall surface protecting member is held at a high temperature, whereby the plasma processing-associated product adhering to the wall surface protecting member can be caused to adhere with high uniformity and adhesive force (peeling lessens).

In the plasma processing apparatus, the wall surface protecting member may be made of a ceramic.
Thus, plasma resistance is enhanced, and a long life is ensured. Also, there can be provided the plasma processing apparatus of a type having plasma generation means which is a coiled antenna wound around the outside of the side wall surface of the chamber.

In the plasma processing apparatus, the wall surface protecting member may be made of a metal, especially, aluminum.
Thus, the member can be improved in durability, and rendered lightweight to lessen the burden of replacement work.

In the plasma processing apparatus, the wall surface protecting member may be a surface oxidized. Thus, its corrosion resistance and wear resistance can be improved.

In the plasma processing apparatus, the wall surface protecting member may have a surface roughened.
Thus, the adhesion of the plasma processing-associated product that has adhered can be improved, and the adhered product can be prevented from peeling off to contaminate the substrate. As a result, the frequency of the cleaning treatment can be decreased.

In the plasma processing apparatus, the gas supply means may be installed passing through a hole provided in the wall surface protecting member.
Thus, a portion of the gas piping exposed to the interior of the plasma processing compartment can be eliminated, making it possible to solve conventional problems such that the plasma processing-associated product adheres to the exposed portion of the piping, becoming the particle source, or necessitating separate cleaning treatment.

In an example not forming part of the invention, the plasma processing apparatus comprises a heat insulator provided between the wall surface protecting member and the chamber.
Thus, the heat loss of the wall surface protecting member heated by the plasma can be suppressed. Also, the wall surface protecting member is supported on the inner wall surface of the vacuum chamber by the heat insulator, so that heat transfer due to direct contact can be eliminated.

The plasma processing apparatus may also be provided with heating means for heating the wall surface of the chamber, especially, the heating means for heating the wall surface of the chamber to 100°C or higher. Thus, the temperature of the wall surface protecting member can be stabilized.

### Brief Description of the Drawings

[Fig. 1] A schematic perspective sectional side view of a thin film production apparatus according to a first embodiment.
[Figs. 2(a) and 2(b)] Fig. 2(a) is an enlarged view of a portion A in Fig. 1. Fig. 2(b) is a schematic outline drawing of a portion of an inner cylinder as viewed from the interior of a vacuum chamber.
[Fig. 3] A sectional enlarged view of a portion surrounding the inner cylinder of a thin film production apparatus according to an example not part of the invention.
[Fig. 4] A sectional enlarged view of a portion surrounding the inner cylinder of a thin filmproduction apparatus according to a second embodiment.
[Fig. 5] A sectional enlarged view of a portion surrounding the inner cylinder of a thin filmproduction apparatus according to a third embodiment.
[Fig. 6] A sectional enlarged view of a portion surrounding the inner cylinder of a thin film production apparatus according to a fourth embodiment.
[Fig. 7] A schematic perspective sectional side view of an example of a conventional thin film production apparatus.

Description of the Numerals: 1 vacuum chamber, 2 film formation compartment, 3 ceiling panel, 4 susceptor, 6 substrate, 7 high frequency antenna, 8 matching instrument, 9 high frequency power source, 10 plasma, 13 gas, 14 gas nozzle, 14a intra-chamber wall gas pipe, 15 thin film, 20 inner cylinder, 20a inner cylinder body, 20b projection, 20c projection, 20d hole portion, 21 chamber step portion, 22 space, 23 heat insulator, 24 gas nozzle, 24a nozzle tipportion, 24b intra-chamber wall gas pipe, 25 gas nozzle, 25a nozzle tip portion, 25b intra-chamber wall gas pipe, 26 gas nozzle, 26a nozzle tip portion, 26b intra-chamber wall gas pipe.

### Best Mode for Carrying Out the Invention

### <First Embodiment>

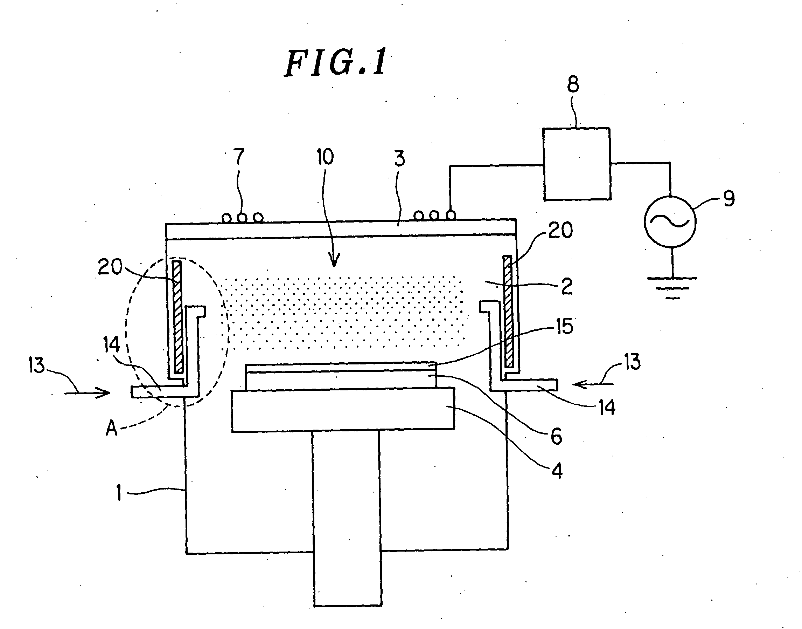

Embodiments of the present invention will now be described for illustrative purposes based on the accompanying drawings. Fig. 1 is a schematic perspective sectional side view of a thin film production apparatus according to a first embodiment of the present invention.

As shown in the drawing, a film formation compartment 2 is defined within a cylindrical vacuum chamber 1, and a circular ceiling panel 3 is provided at the top of the vacuum chamber 1. A susceptor 4 for supporting a substrate 6 is set at the center of the film formation compartment 2, and the substrate 6 of a semiconductor is electrostatically attracted to and held on the upper surface of the susceptor 4, for example, by an electrostatic chuck.

A high frequency antenna 7, for example, shaped like a circular ring is disposed on the ceiling panel 3, and a high frequency power source 9 is connected to the high frequency antenna 7 via a matching instrument 8. Electric power is supplied to the high frequency antenna 7 to throw an electromagnetic wave into the film formation compartment 2 of the vacuum chamber 1 (plasma generation means).

Gas nozzles 14, which are gas supply means, are provided to introduce a gas 13 at a position lower than the ceiling panel 3, but higher than the susceptor 4, within the film formation compartment 2. In order to heighten the degree of freedom of the periphery of the outside of the vacuum chamber 1, the gas nozzles 14 are fixed at lower sites of the side wall portion of the vacuum chamber 1, and are extended upward within the film formation compartment 2, whereby the position of the nozzle tips (gas injection ports) is rendered lower than the ceiling panel 3, but higher than the susceptor 4.

The gas 13 introduced into the film formation compartment 2 is ionized by an electromagnetic wave thrown into the film formation compartment 2 to assume a state of plasma. The gas 13 is a gas containing an elemental component becoming a material for a thin film 15, for example, a gas of an organometallic complex. After change into the state of plasma, the gas is, for example, adsorbed to the substrate 6 to form the thin film 15. For example, a metallic thin film is formed from the gas of the organometallic complex, and a boron nitride film is formed from a combination of an ammonia gas and a diborane gas. The thin films 15 of various types can be formed by changing the type of the gas.

As details of apparatus control, the interior of the film formation compartment 2 is adjusted to a predetermined pressure, for example, by a vacuum pump (not shown) as a pressure control means, and the gas 13 is introduced at a predetermined flow rate from the gas nozzles 14. High frequency power (1 MHz to 100 MHz, 1 kW to 10 kW) is applied from the high frequency power source 9 to the high frequency antenna 7 via the matching instrument 8, whereby the gas 13 is excited within the film formation compartment 2 to turn into a plasma state, thereby forming the thin film 15 on the substrate 6. At this time, the temperature of the substrate 6 is set at 200°C to 450°C, for example, by a heater (not shown) as a temperature control means.

In order that the thin film component does not adhere to the inner wall surface of the vacuum chamber 1 on this occasion, an inner cylinder 20 made of a ceramic, as a wall surface protecting member, is provided in the present embodiment. The inner cylinder 20 is a cylindrical member which covers the inner wall surface of the vacuum chamber 1 located above the susceptor 4.

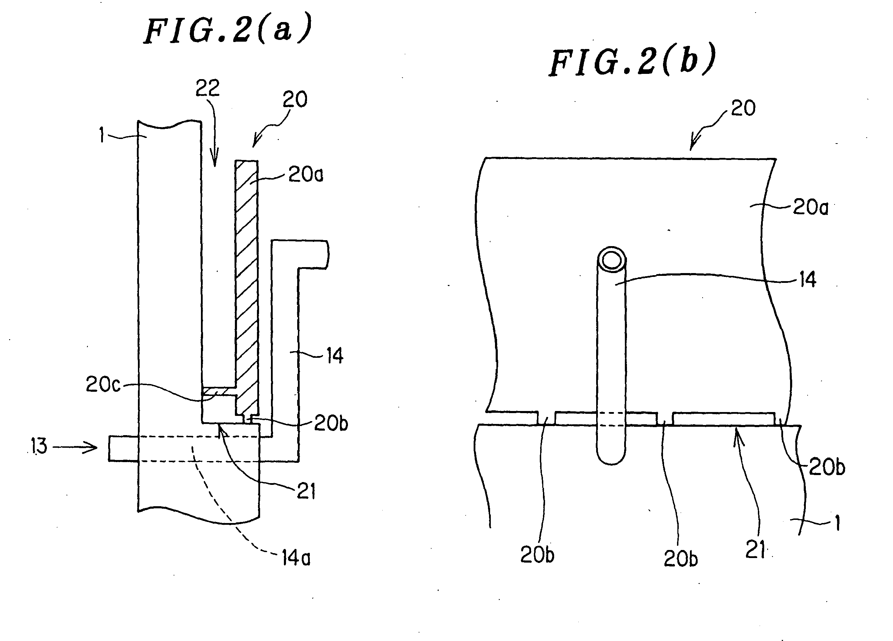

Fig. 2 (a) is an enlarged view of a portion A in Fig. 1, and is a view for illustrating in detail the inner cylinder 20 provided within the vacuum chamber 1. As shown in this drawing, the inner cylinder 20 is composed of an inner cylinder body 20a and projections 20b, 20c. The inner cylinder body 20a is in the shape of a cylinder insertible into the interior of the cylindrical vacuum chamber 1 and having a smaller diameter than the diameter of the vacuum chamber 1.

The vacuum chamber 1 is provided with a chamber step portion 21 which can support the inner cylinder 20 from below throughout the circumference thereof. The projections 20b provided in a lower end portion of the inner cylinder 20 are supported from below by the chamber step portion 21, whereby the downward movement of the inner cylinder 20 within the vacuum chamber 1 is restrained. Also, the projections 20c provided on the outer wall surface of the inner cylinder 20 contact the inner wall surface of the vacuum chamber 1, thereby preventing the lateral displacement of the inner cylinder 20 within the vacuum chamber 1.

Fig. 2(b) is a schematic outline drawing of a portion of the inner cylinder 20 as viewed from the interior of the vacuum chamber 1. As shown in the drawing, the projections 20b are provided interruptedly and projectively along the circumference in a lower end portion of the inner cylinder body 20a of a cylindrical form. The number of the projections 20b may be such a number or larger that the inner cylinder body 20a can be supported on the chamber step portion 21. The projections 20c are provided interruptedly and projectively along the circumference of the cylinder, as are the projections 20b, on the outer wall surface of the inner cylinder body 20a. The number of the projections 20c may be 2 or 3 or more. From the point of view of the retention heat of the inner cylinder 20 to be described later in detail, smaller numbers of the projections 20b and 20c are better.

Moreover, the gas nozzle 14 is disposed to extend upward in the interior of the vacuum chamber 1 so as to supply the gas 13 horizontally into the film formation compartment 2 via an intra-chamber wall gas pipe 14a provided straightly from the outside to the inside of the chamber 1 below the inner cylinder 20 in the vacuum chamber 1. The adhesion of the thin film component to the inner wall of the chamber during the film formation process is particularly apt to occur at a height at which the gas 13 is supplied, namely, at the height of the nozzle tip of the gas nozzle 14. As shown in Fig. 2(a), therefore, the inner cylinder 20 is provided to reach such a height as to sufficiently cut off the inner wall surface of the vacuum chamber 1 and the nozzle tip of the gas nozzle 14 from each other.

By providing the inner cylinder 20, the inner wall surface of the inner cylinder 20 is contaminated with the thin film component. Thus, the film formation process can be performed without contamination of the inner wall surface of the vacuum chamber 1. Consequently, when the interior of the chamber is to be cleaned, the inner cylinder 20 may be detached from the vacuum chamber 1, and cleaning may be carried out. As a result, cleaning treatment becomes easy. Also, a plurality of the inner cylinders 20 are rendered ready for use, thereby making it possible to prepare thin films continuously without lowering the productivity.

During the film formation process, the inner cylinder 20 is heated to about 200°C to 400°C by a plasma 10 generated within the film formation compartment 2. As a result, the thin film component adhering to the wall surface of the inner cylinder 20 is a highly adherent thin film component of an improved film quality, and its peeling, for example, minimally occurs even if it is deposited. Thus, the thin film component adhering to the inner cylinder 20 hardly becomes a particle source contaminating the substrate 6, as compared with the thin film component adhering to the conventional vacuum chamber.

The reasons are that the inner cylinder 20 is heated more easily than the vacuum chamber 1 because of the thickness (as small as about 3 to 5 mm) of the inner cylinder 20, its material, etc., and that the inner cylinder 20 is supported on the vacuum chamber 1 by the projections 20b, 20c, so to speak, supported by point contact; therefore, heat conducted from the inner cylinder 20 to the vacuum chamber 1 is, only slightly, conduction heat due to contact between the two members, but mostly, can be limited to radiant heat conducted via a space 22.

In the present embodiment, as noted above, it is also important to maintain the temperature of the inner cylinder 20 at a high temperature. Thus, if the temperature of the inner cylinder 20 is unstable, it is desirable to install a heatingmeans, such as a heater, for heating the side wall portion of the vacuum chamber 1, in order to stabilize the temperature of the inner cylinder 20. The heating temperature is desirably 100°C or higher.

As described above, the thin film component adhering to the wall surface of the inner cylinder 20 can be rendered a minimally peeling one. As a result, the film thickness of a film, which can be formed at a stroke, can be increased (about 1 µm conventionally, about 10 µm in the present embodiment), and the frequency of cleaning of the thin film component adhering to the inner cylinder 20 can be decreased.

Furthermore, the temperature of the inner cylinder 20 can be rendered as high as 200°C to 400°C by heating with plasma. Thus, if cleaning treatment (cleaning by etching using plasma) is performed, with the inner cylinder 20 being installed within the chamber, the etching rate, namely, the cleaning speed, can be raised. This is a solution to the conventional problem that when the inner wall surface of the vacuum chamber 1 is cleaned, the vacuum chamber 1 is difficult to heat, and thus its heating with plasma alone is insufficient, resulting in a low cleaning speed. That is also a solution to the problem that a heating device or the like for raising the chamber temperature needs to be separately provided in order to increase the cleaning speed.

Hereinbelow, an example not forming part of the invention and second to fourth embodiments will be described as modifications of the first embodiment.

### < Example (not part of the invention) >

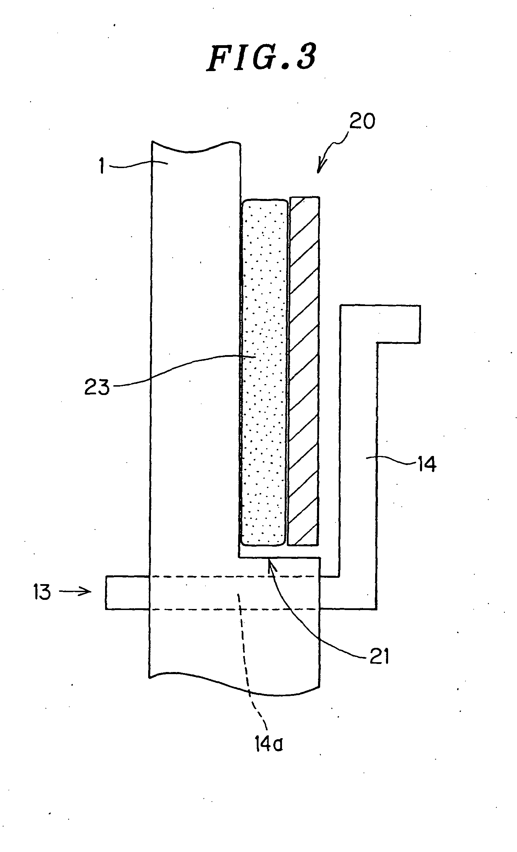

Fig. 3 is a sectional enlarged view of a portion surrounding the inner cylinder (corresponding to the portion A in Fig. 1) of a thin film production apparatus according to an example not part of the present invention. In the present example, as shown in the drawing, a heat insulator 23 is sandwiched between the inner cylinder 20 and the vacuum chamber 1 (corresponding to the space 22 in Fig. 2). The sandwiched heat insulator 23 is compressed, and plays the role of supporting the inner cylinder 20 on the vacuum chamber 1.

Thus, the inner cylinder 20 in the present embodiment need not be provided with the projections 20b and 20c in the first embodiment, and still it is possible to completely eliminate heat conduction from the inner cylinder 20 to the vacuum chamber 1 by point contact. Moreover, the heat loss of the inner cylinder 20 can be suppressed by installing the heat insulator 23.

Teflon (registered trademark) and polyimide are named as the heat insulator.

### <Second Embodiment>

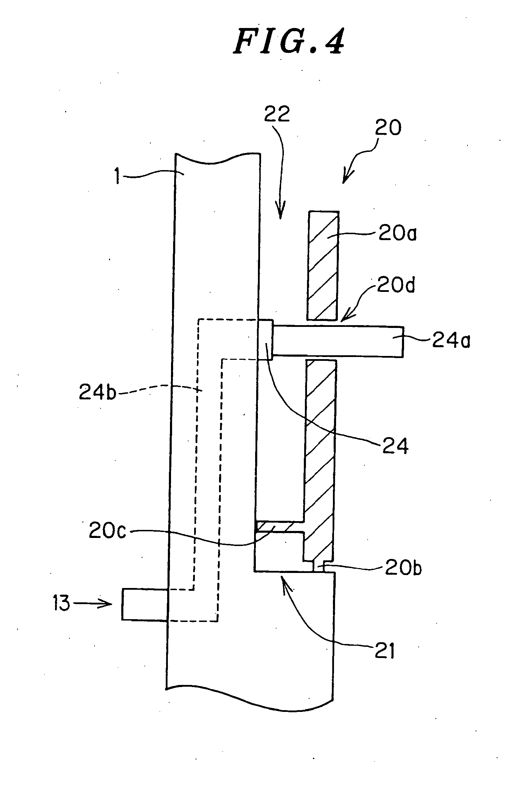

Fig. 4 is a sectional enlarged view of a portion surrounding the inner cylinder (corresponding to the portion A in Fig. 1) of a thin film production apparatus according to a second embodiment of the present invention. In the present embodiment, as shown in the drawing, the inner cylinder 20 is provided with a hole portion 20d for allowing a gas nozzle 24 to pass therethrough. The gas nozzle 24 is disposed to feed the gas 13 from the outside of the vacuum chamber 1 and supply the gas 13 horizontally from a nozzle tip portion 24a into the film formation compartment 2 via an intra-chamber wall gas pipe 24b, the nozzle tip portion 24a constituting a nozzle tip inside the vacuum chamber 1 and being installed to pass through the hole portion 20d, the intra-chamber wall gas pipe 24b being provided to start at a site in the vacuum chamber 1 below the inner cylinder 20, extend upward within the wall of the vacuum chamber 1, and communicate horizontally with the interior of the vacuum chamber 1 (film formation compartment 2).

In the first embodiment, the gas nozzle is disposed within the vacuum chamber further inwardly of the inner cylinder (the portion extending upward in the chamber). That is, the gas piping exposed to the interior of the chamber is present. Thus, the thin film component adheres to this piping portion, requiring separate cleaning. In the second embodiment on the other hand, the portion of the gas nozzle 24 exposed to the interior of the film formation compartment 2 is only the minimum portion, namely, the nozzle tip portion 24a, thus obviating the need for separate cleaning.

The nozzle tip portion 24a is detachable from the gas nozzle body. Thus, when the inner cylinder 20 is to be removed from the vacuum chamber 1, the nozzle tip portion 24a is detached in the lateral direction, and then the inner cylinder 20 is detached upward.

### <Third Embodiment>

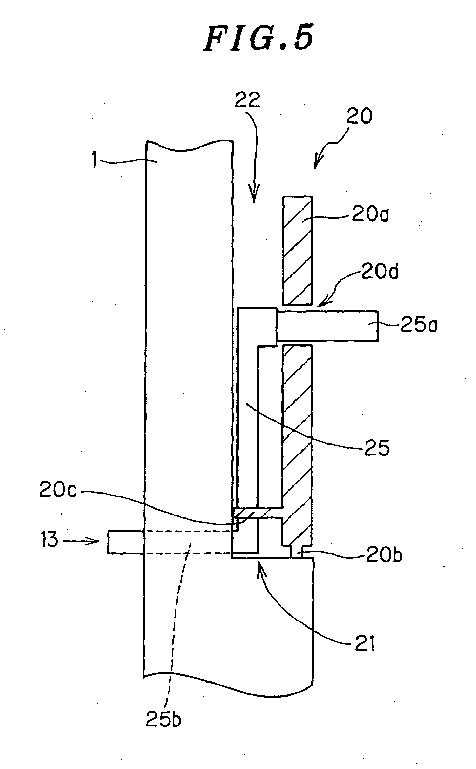

Fig. 5 shows a third embodiment which is a modification of the above second embodiment. In the present embodiment, a piping portion corresponding to the intra-chamber wall gas pipe 24b in Fig. 4 is disposed in a space 22 between the inner cylinder 20 and the vacuum chamber 1, namely, in the outside of the chamber wall, and a piping portion formed within the wall of the vacuum chamber 1 is an intra-chamber wall gas pipe 25b alone.

In the case of the present embodiment, the piping formed in the vacuum chamber 1 may be only the straight intra-chamber wall gas pipe 25b, which can be rendered simple compared with the intra-chamber wall gas pipe 24b shown in Fig. 4. Moreover, the piping portion exposed to the interior of the chamber is only the nozzle tip portion 25a, as in the second embodiment shown in Fig. 4. Likewise, therefore, separate cleaning can be rendered unnecessary.

### <Fourth Embodiment>

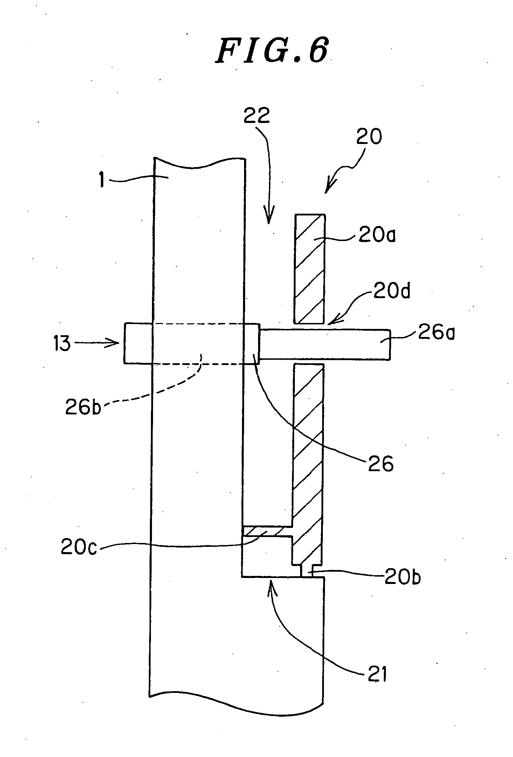

Fig. 6 shows a fourth embodiment which is a modification of the aforementioned third embodiment (see Fig. 4). In the present embodiment, a piping portion corresponding to the intra-chamber wall gas pipe 24b in Fig. 4 is a straight intra-chamber wall gas pipe 26b.

In the case of the present embodiment, the height of the outside of the vacuum chamber 1, at which the gas 13 is supplied, is nearly the same as the height in the interior of the chamber at which the gas 13 is introduced. Since the gas supply means is provided, the degree of freedom of the periphery of the outside of the side wall of the vacuum chamber 1 is low. However, if there are a few components installed around the outside of the side wall of the vacuum chamber 1, as in the apparatus of the type having no coiled antenna provided around the chamber as the plasma generation means, for example, a simpler gas nozzle can be provided by adopting the gas nozzle structure shown in Fig. 6.

The present invention is not limited to the above-described embodiments. For example, aluminum, etc. in addition to ceramics are named as the materials for the inner cylinder. In the case of the inner cylinder made of aluminum, oxidation of its surface can enhance corrosion resistance and wear resistance. Furthermore, roughening treatment, such as blasting, of the surface of the inner cylinder can enhance the adhesion of the thin film component, regardless of the material for the inner cylinder. According to an alternative example not part of the invention, the projections 20b, 20c provided on the inner cylinder 20 may be provided on the vacuum chamber 1.

### Industrial Applicability

The plasma processing apparatus according to the present invention is an apparatus which has obviated the necessity for cleaning treatment of the interior of the chamber, or has decreased the frequency of the cleaning treatment, or has reduced the burden of work for the cleaning treatment. Therefore, this apparatus can be applied to a film forming operation requiring high productivity.

## Claims

1. A plasma processing apparatus, comprising:
gas supply means (14) for supplying a gas (13) including a reactant gas to an interior of a chamber (1);
pressure control means for controlling an internal pressure of the chamber;
plasma generation means (7) for generating a plasma of the gas in the interior of the chamber;
a susceptor (4), installed in a lower portion of the interior of the chamber, for supporting a substrate (6) to be processed, and
a wall surface protecting member (20) formed in a cylindrical form and provided in the interior of the chamber, for preventing adhesion of a plasma processing-associated product onto an inner wall surface of the chamber,
a chamber step portion (21) provided to the inner wall surface of the chamber (1) arranged to support the wall surface protecting member (20) from below so as to cover the inner surface of the chamber (1) which is located above the susceptor (4),
**characterized by**
a plurality of projections (20b, 20c) provided on an outer wall surface and in a lower end portion of the wall surface protecting member (20) said plurality of projections being arranged to contact by point the inner wall surface of the chamber (1) and the chamber step portion (21), wherein
the wall surface protecting member (20) is supported on the chamber (1) by point contact through said plurality of projections.

2. The plasma processing apparatus according to claim 1, further **characterized in that** the wall surface protecting member (20) is made of a ceramic.

3. The plasma processing apparatus according to claim 1, further **characterized in that** the wall surface protecting member (20) is made of a metal.

4. The plasma processing apparatus according to claim 3, further **characterized in that** the metal is aluminum.

5. The plasma processing apparatus according to claim 3 or 4, further **characterized in that** the wall surface protecting member (20) has a surface oxidized.

6. The plasma processing apparatus according to any one of claims 1 to 5, further **characterized in that** the wall surface protecting member (20) has a surface roughened.

7. The plasma processing apparatus according to any one of claims 1 to 6, further **characterized in that** the gas supply means is installed while passing through a hole (20d) provided in the wall surface protecting member (20).

8. The plasma processing apparatus according to any one of claims 1 to 7, further comprising heating means for heating a wall surface of the chamber.

9. The plasma processing apparatus according to claim 8, further **characterized in that** the heating means heats the wall surface of the chamber to 100°C or higher.

## Patentansprüche

1. Plasmabearbeitungsvorrichtung, die umfasst:
ein Gaszufuhrmittel (14) zum Zuführen von Gas (13), das ein Reaktantgas enthält, in einen Innenbereich einer Kammer (1);
ein Drucksteuermittel zum Steuern eines Innendrucks der Kammer;
ein Plasmaerzeugungsmittel (7) zum Erzeugen eines Plasmas von dem Gas in dem Innenbereich der Kammer;
einen Suszeptor (4), der in einem unteren Abschnitt des Innenbereichs der Kammer installiert ist, zum Unterstützen eines zu bearbeitenden Substrats (6), und
ein Wandoberflächenschutzelement (20), das in einer zylindrischen Form ausgebildet ist und in dem Innenbereich der Kammer vorgesehen ist, zum Vermeiden einer Anhaftung eines Produkts, das mit der Plasmabearbeitung assoziiert ist, an einer Innenwandoberfläche der Kammer,
einen Kammerstufenabschnitt (21), der an der Innenwandoberfläche der Kammer (1) vorgesehen ist, der angeordnet ist, um das Wandoberflächenschutzelement (20) von unten so zu unterstützen, dass die Innenoberfläche der Kammer (1), die oberhalb des Suszeptors (4) positioniert ist, abgedeckt wird,
**gekennzeichnet durch** eine Mehrzahl von Vorsprüngen (20b, 20c), die auf einer Außenwandoberfläche und in einem unteren Endabschnitt des Wandoberflächenschutzelements (20) vorgesehen sind, wobei die Mehrzahl von Vorsprüngen vorgesehen ist, um mit der Innenwandoberfläche der Kammer (1) und des Kammerstufenabschnitts (21) im Punktkontakt zu stehen, wobei
das Wandoberflächenschutzelement (20) an der Kammer (1) mittels Punktkontakts **durch** die Mehrzahl von Vorsprüngen unterstützt ist.

2. Plasmabearbeitungsvorrichtung nach Anspruch 1, ferner **dadurch gekennzeichnet, dass** das Wandoberflächenschutzelement (20) aus Keramik gefertigt ist.

3. Plasmabearbeitungsvorrichtung nach Anspruch 1, ferner **dadurch gekennzeichnet, dass** das Wandoberflächenschutzelement (20) aus Metall gefertigt ist.

4. Plasmabearbeitungsvorrichtung nach Anspruch 3, ferner **dadurch gekennzeichnet, dass** das Metall Aluminium ist.

5. Plasmabearbeitungsvorrichtung nach Anspruch 3 oder 4, ferner **dadurch gekennzeichnet, dass** bei dem Wandoberflächenschutzelement eine Oberfläche oxidiert ist.

6. Plasmabearbeitungsvorrichtung nach einem der Ansprüche 1 bis 5, ferner **dadurch gekennzeichnet, dass** bei dem Wandoberflächenschutzelement (20) eine Oberfläche aufgeraut ist.

7. Plasmabearbeitungsvorrichtung nach einem der Ansprüche 1 bis 6, ferner **dadurch gekennzeichnet, dass** das Gaszufuhrmittel installiert ist, während dieses durch eine Öffnung (20d) tritt, die in dem Wandoberflächenschutzelement (20) vorgesehen ist.

8. Plasmabearbeitungsvorrichtung nach einem der Ansprüche 1 bis 7, die ferner ein Heizmittel zum Erhitzen einer Wandoberfläche der Kammer umfasst.

9. Plasmabearbeitungsvorrichtung nach Anspruch 8, ferner **dadurch gekennzeichnet, dass** das Heizmittel die Wandoberfläche der Kammer auf 100° oder mehr erhitzt.

## Revendications

1. Appareil de traitement au plasma, comprenant :
un moyen d'amenée de gaz (14) pour amener un gaz (13) incluant un gaz réactif jusqu'à un intérieur d'une chambre (1) ;
un moyen de commande de pression pour commander une pression interne de la chambre ;
un moyen de génération de plasma (7) pour générer un plasma du gaz dans l'intérieur de la chambre ;
un suscepteur (4), installé dans une partie inférieure de l'intérieur de la chambre, pour supporter un substrat (6) destiné à être traité, et
un élément de protection de surface de paroi (20) formé en une forme cylindrique et prévu dans l'intérieur de la chambre, pour empêcher une adhérence d'un produit associé au traitement au plasma sur une surface de paroi interne de la chambre,
une partie de chambre en escalier (21) prévue au niveau de la surface de paroi interne de la chambre (1) agencée pour supporter l'élément de protection de surface de paroi (20) par en-dessous de façon à couvrir la surface intérieure de la chambre (1) qui est située au-dessus du suscepteur (4),
**caractérisé par**
une pluralité de saillies (20b, 20c) prévues sur une surface de paroi extérieure et dans une partie d'extrémité inférieure de l'élément de protection de surface de paroi (20), ladite pluralité de saillies étant agencées pour un contact par points avec la surface de paroi intérieure de la chambre (1) et la partie de chambre en escalier (21), dans lequel
l'élément de protection de surface de paroi (20) est supporté sur la chambre (1) par contact par points par l'intermédiaire de ladite pluralité de saillies.

2. Appareil de traitement au plasma selon la revendication 1, **caractérisé en outre en ce que** l'élément de protection de surface de paroi (20) est constitué d'une céramique.

3. Appareil de traitement au plasma selon la revendication 1, **caractérisé en outre en ce que** l'élément de protection de surface de paroi (20) est constitué d'un métal.

4. Appareil de traitement au plasma selon la revendication 3, **caractérisé en outre en ce que** le métal est l'aluminium.

5. Appareil de traitement au plasma selon la revendication 3 ou 4, **caractérisé en outre en ce que** l'élément de protection de surface de paroi (20) a une surface oxydée.

6. Appareil de traitement au plasma selon l'une quelconque des revendications 1 à 5, **caractérisé en outre en ce que** l'élément de protection de surface de paroi (20) a une surface rugosifiée.

7. Appareil de traitement au plasma selon l'une quelconque des revendications 1 à 6, **caractérisé en outre en ce que** le moyen d'amenée de gaz est installé en passant à travers un trou (20d) prévu dans l'élément de protection de surface de paroi (20).

8. Appareil de traitement au plasma selon l'une quelconque des revendications 1 à 7, comprenant en outre un moyen de chauffage pour chauffer une surface de paroi de la chambre.

9. Appareil de traitement au plasma selon la revendication 8, **caractérisé en outre en ce que** le moyen de chauffage chauffe la surface de paroi de la chambre à 100°C ou plus.
